# EUROPEAN PATENT SPECIFICATION

(11) **EP 4 068 921 B1**
(45) Date of publication and mention of the grant of the patent: **17.07.2024**
(21) Application number: 21306172.4
(22) Date of filing: 30.08.2021
(51) Int. Cl.: H05K 7/14, H05K 7/20, G06F 1/20

(54) **IMMERSION COOLING SYSTEMS FOR ELECTRONIC COMPONENTS**
TAUCHKÜHLSYSTEME FÜR ELEKTRONISCHE BAUTEILE
SYSTÈMES DE REFROIDISSEMENT PAR IMMERSION POUR COMPOSANTS ÉLECTRONIQUES

(30) Priority: 01.04.2021 EP 21305427
(43) Date of publication of application: 05.10.2022
(73) Proprietor: OVH, 59100 Roubaix (FR)
(72) Inventor: CHEHADE, Ali, 59283 Moncheaux (FR); BAUCHART, Grégory Francis Louis, 59150 Wattrelos (FR); MENEBOO, Alexandre Alain Jean-Pierre, 62440 Harnes (FR)
(74) Representative: BCF Global

(56) References cited:
- JP-A- 2020 065 002
- US-A1- 2018 042 138
- US-A1- 2018 295 745

## Description

### CROSS-REFERENCE TO RELATED APPLICATION

The present application claims priority to European Patent Application EP21305427, which was filed on April, 1st 2021.

### TECHNICAL FIELD

The present technology relates to immersion cooling systems for cooling of electronic components of electronic equipment in computing infrastructures, and more specifically, but not limited to, immersion cooling systems in which a level of the immersion fluid can be modulated.

### BACKGROUND

Electronic equipment, for example servers, memory banks, computer discs, and the like, is conventionally grouped in equipment racks. Large data centers and other large computing infrastructures may contain thousands of racks supporting thousands or even tens of thousands of servers and other electronic equipment.

The electronic equipment mounted in the racks consume large amounts of electric power and generates significant amounts of heat. Cooling needs are important in such racks. Some electronic equipment, such as processors, generate so much heat that they could fail within seconds in case of a lack of cooling. Moreover, with advancing technological progress, electronic equipment for computing purposes is not only becoming more performant but also has a greater associated thermal design power (TDP) (i.e., a maximum amount of heat generated thereby which a cooling system should dissipate) thus emphasizing the need to improve cooling solutions.

Forced air-cooling has been traditionally used to disperse heat generated by such electronic equipment mounted in the racks. Air-cooling requires the use of powerful fans, and the provision of space between the electronic equipment or between electronic components of a given electronic equipment. The space is used for placing heat sinks and for allowing sufficient airflow. However, such forced air-cooling methods are generally not very efficient.

JP2020 065002 A discloses a liquid level height adjustment apparatus for a liquid immersion tank.

Liquid-cooling technologies are increasingly used as an efficient and cost-effective solution to maintain safe operating temperatures of electronic equipment, such as servers, mounted in racks. Such liquid-cooling technologies include immersion cooling systems in which the electronic component is submerged in an immersion cooling liquid within an immersion case.

It is an object of the present technology to provide improvements to conventional immersion cooling systems.

### SUMMARY

Developers have noted certain drawbacks in conventional immersion cooling system.

For example, there exist different types and combinations of electronic components having different cooling requirements and requiring different volumes of the immersion cooling liquid to achieve the cooling requirements. Such different types and combinations of the electronic components will thus require different volumes of the immersion cooling liquid. In some cases, the electronic component takes up a small amount of the volume within the immersion case thus requiring relatively larger volume of the immersion cooling liquid to fill the immersion case to a predetermined level. However, the immersion cooling liquid is an expensive component of conventional immersion systems. Therefore, Developers have noted that it may be advantageous to minimize a volume of the immersion cooling liquid for cost purposes whilst meeting a minimum requirement to achieve an adequate cooling of the electronic component.

Furthermore, Developers have noted that it would be convenient to be able to quickly and efficiently modulate the level of the immersion cooling liquid within an immersion case, such as during transportation of the immersion case particularly in cases where the immersion case is not sealed. Being able to modulate the level of the immersion cooling liquid could also provide more ready access to the electronic component which is submerged in the immersion cooling liquid without requiring draining of the immersion cooling liquid.

It is an object of the present technology to ameliorate at least some of the inconveniences present in the prior art.

Broadly, aspects of the cooling system of the present technology provide a bladder configurable between an expanded state and a contracted state and which can be disposed in an immersion case configured to receive an electronic component and immersion cooling liquid, the immersion cooling liquid cooling the electronic component. Modulation of the bladder between the expanded and contracted states modulates a volume of the bladder within the immersion cooling liquid in use, thus enabling a modulation of a level of the immersion cooling liquid in use. A controller can modulate the state of the bladder to change immersion cooling liquid fluid level so as to effectively submerge the electronic component or to reduce fluid level in the immersion case.

Accordingly, the invention defines a cooling system according to claim 1 and a method for operating a cooling system according to claim 12, further embodiments are defined by the dependent claims. The embodiments of the present technology can provide an efficient way of modulating a level of the immersion cooling fluid in the immersion case, such as during transportation of the immersion case when the level can be reduced to avoid spillage of the valuable immersion cooling fluid. Advantageously, embodiments of the present technology can also modulate a volume of the immersion cooling liquid required to effectively cool an electronic component. More specifically, the bladder of the present technology can reduce a volume of the immersion cooling liquid within an immersion case.

According to one aspect of the present technology, there is provided a cooling system including an immersion case, a bladder and a controller. The immersion case is configured to house an immersion cooling liquid, and an electronic component configured to be submerged in the immersion cooling liquid. The bladder is configurable between an expanded state and a contracted state and positioned such that the bladder can be at least partially submerged in the immersion cooling liquid when in any one of the expanded state and the contracted state. The controller connected to the bladder for modulating the bladder between the expanded state and the contracted state to modulate a fluid level of the immersion cooling liquid in the immersion case.

In some embodiments, the bladder includes at least one fold, the at least one fold being unfolded in the expanded state and folded in the contracted state.

In some embodiments, the bladder is made of a material which is thermally resistant up to at least 60°C.

In some embodiments, the bladder is configured to be anchored to the immersion case such that the bladder remains at least partially submerged in the immersion cooling liquid when in the expanded state and the contracted state, the bladder is submerged in the immersion cooling liquid when in the expanded state only, or the bladder contacts the electronic component in at least one of the expanded state and the contracted state.

In some embodiments, the bladder is configured to house a bladder fluid, the bladder fluid being a gas or a liquid, and the cooling system including a pump communicatively connected to the controller and fluidly connected to the bladder, the pump being configured to move the bladder fluid in and out of the bladder.

In some embodiments, the reservoir is fluidly connected to the pump.

In some embodiments, the cooling system further includes a level sensor configured to detect the level of the immersion cooling liquid in the immersion case.

In some embodiments, the controller is communicatively connected to the level sensor and to the pump, the controller being configured to control the bladder state in response to data received from the level sensor.

In some embodiments, the bladder includes a plurality of bladders which are fluidly connected to one another.

The cooling system further includes a rack system configured to receive the immersion case.

When one of the rack system, having received the immersion case, and the immersion case is displaced, the controller modulates the bladder to the contracted state.

The immersion case is configured such that when the bladder is in the expanded state, the level of the immersion cooling liquid is at a first level in the immersion case and the electronic component is submerged in the immersion cooling liquid. When the bladder is in the contracted state, the level of the immersion cooling liquid is at a second level in the immersion case, the second level being lower than the first level.

According to another aspect of the present technology, there is provided a method for operating a cooling system. The cooling system includes an immersion case housing immersion cooling liquid, an electronic component, and a bladder. The method is executed by a processor of a computer system communicatively coupled to a controller of the cooling system. The method includes modulating the bladder between an expanded state and a contracted state. The bladder is positioned in the immersion case such that the bladder is at least partially submerged in the immersion cooling liquid when in any one of the expanded state and the contracted state to modulate a level of the immersion cooling liquid in the immersion case and to selectively submerge the electronic component.

In some embodiments, the method further includes detecting the level of the immersion cooling liquid in the immersion case or a volume of the bladder, and responsive to the detected level of the immersion cooling liquid being a predetermined level or the volume of the bladder being at a predetermined volume, causing the modulation of the bladder.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

It must be noted that, as used in this specification and the appended claims, the singular form "a", "an" and "the" include plural referents unless the context clearly dictates otherwise.

As used herein, the term "and/or" is to be taken as specific disclosure of each of the two specified features or components with or without the other. For example "A and/or B" is to be taken as specific disclosure of each of (i) A, (ii) B and (iii) A and B, just as if each is set out individually herein.

Additional and/or alternative features, aspects and advantages of embodiments of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
Figure 1 is a perspective view taken from a front, top, left side of a cooling system in accordance to an embodiment of the present technology;
Figure 2 is a perspective view taken from a top, left side of an immersion case of the cooling system of Figure 1 with a bladder housed in the immersion case being in a contracted state;
Figure 3 is a perspective view taken from a top, left side of an immersion case of the cooling system of Figure 1 with the bladder housed in the immersion case being in an expanded state;
Figure 4a a is a perspective view taken from a top, left side of a bladder in accordance to an embodiment of the present technology, the bladder being in a contracted state;
Figure 4b is a perspective view taken from a top, left side of the bladder of Figure 4b in an expanded state;
Figure 5a is a left side elevation view of a bladder in accordance to an alternate embodiment of the present technology, the bladder being in a contracted state;
Figure 5b is a left side elevation view of the bladder of Figure 5a in an expanded state;
Figure 6a is a perspective view taken from a top, left side of a bladder in accordance to an alternate embodiment of the present technology, the bladder being in a contracted state;
Figure 6b is a perspective view taken from a top, left side of the bladder of Figure 6a in a contracted state;
Figure 7a is a left side elevation view of a bladder in accordance to an alternate embodiment of the present technology, the bladder being in a contracted state;
Figure 7b is a left side elevation view of the bladder of Figure 7a in an expanded state; and

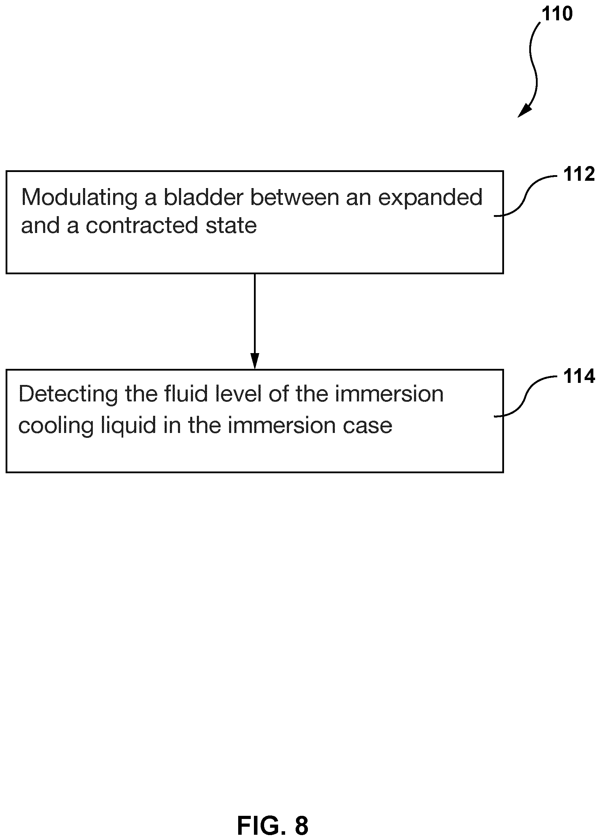

Figure 8 is flowchart of a method for operating the cooling system of Figure 1.

The various Figures are not to scale.

### DETAILED DESCRIPTION

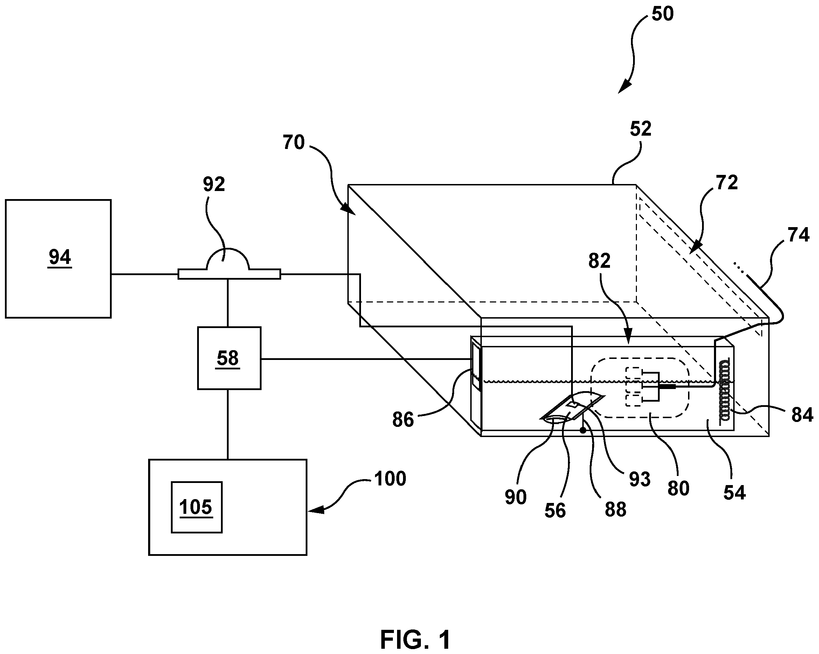

Referring to Fig. 1, according to a broad aspect of the present technology, there is provided a cooling system 50 which includes a rack system 52 and a plurality of immersion cases 54 (only one immersion case 54 is shown in the accompanying Figures). The cooling system 50 also includes a bladder 56 and a controller 58.

The rack system 52 defines a front opening 70, which in part, enables racking and deracking operations of the immersion case 54. The rack system 52 also defines a rear opening 72 configured to accommodate a cable/tube bundle 74 therethrough. In some embodiments, the rear opening 72 could accommodate a plurality of cable/tube bundles 74 therethrough. The rack system 52 has a single shelf that is configured to house the plurality of immersion cases 54. In some embodiments, the rack system 52 could be configured to house a single immersion case 54. In other embodiments, the rack system 52 could have two or more shelves positioned substantially vertically in the rack system 52.

The immersion case 54 is configured to receive, and house, immersion cooling liquid and an electronic component 80 in a cavity therein. An upper aperture 82 is provided for access to the cavity. In other embodiments, access to the cavity of the immersion case 54 may be provided in a different manner such as from a side aperture or through a sealable portal. The electronic component 80, which can be submerged in the immersion cooling liquid, may, for example, comprise a server, a hard disk drive, a power supply, and the like. The immersion case 54 is also configured to receive and house a serpentine convection coil 84 therein. It is contemplated that in some embodiments, the serpentine convection coil 84 could be another type of heat exchanger. In some embodiments, the immersion case 54 could be configured to receive two or more electronic components 80 and/or two or more serpentine convection coils 84 therein. As will also be described below, the immersion cooling liquid can aid in cooling the electronic component 80 and in heat exchange through the serpentine convection coil 84. In other embodiments, the serpentine convention coil 84 may be omitted.

In certain embodiments, the cooling system 50 also includes a level sensor 86 that is connected to the immersion case 54 and that is communicatively connected to the controller 58. The level sensor 86 is configured to detect fluid level (i.e. height) of the immersion cooling liquid within the immersion case 54, and communicate said fluid level to the controller 58. In certain other embodiments, the cooling system 50 may omit the level sensor 86.

The cable/tube bundle 74 services the immersion case 54 by carrying hot and/or cold fluid and/or electrical current in and/or out the immersion case 54. In some embodiments, the fluid carried by the cable/tube bundles 74 is water. The cable/tube bundle 74 is operatively connected to water blocks (not shown) of the electronic component 80 and to the serpentine convection coil 84.

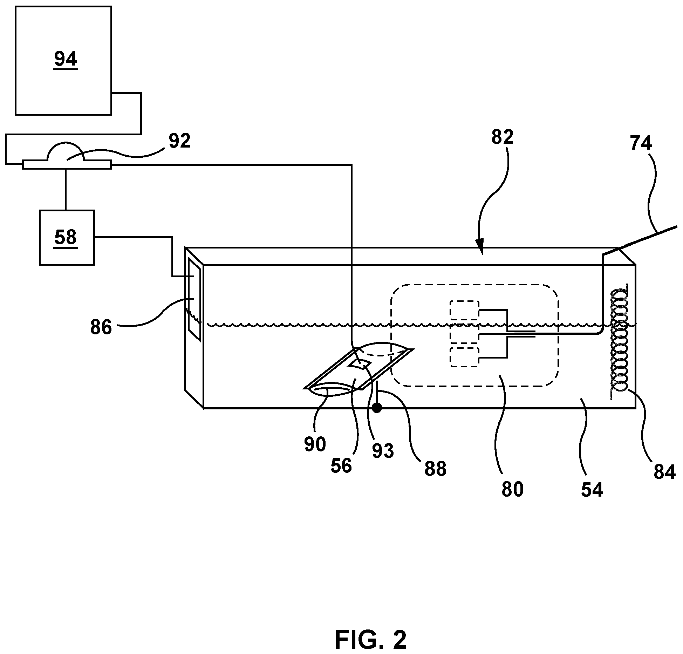

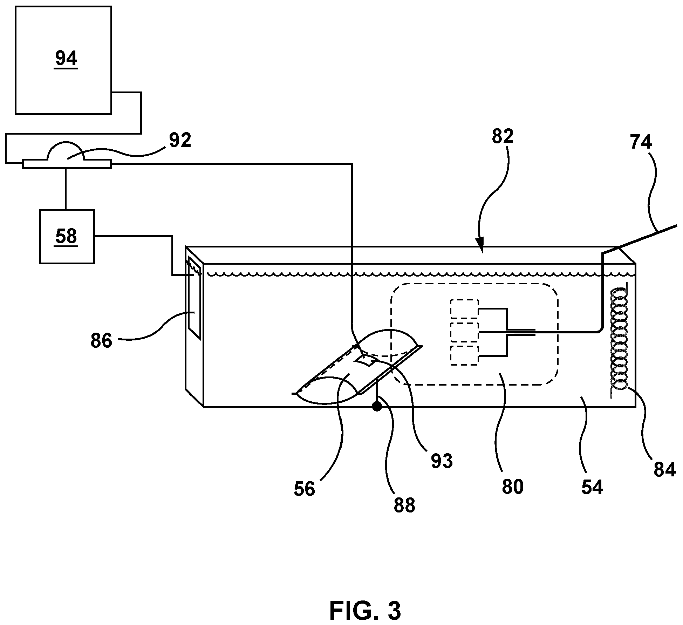

The bladder 56, which is configurable between an expanded state (Figure 3) and a contracted state (Figure 2), is disposed within the immersion case 54. It is understood that in some embodiments, the bladder 56 could be configured to states between the expanded and contracted states such as, for example, a partially contracted state. A volume occupied by the bladder 56 in the expanded state is more than a volume occupied by the bladder 56 in the contracted state. Thus, when the bladder 56 is at least partially submerged in the immersion cooling liquid, modulation of the fluid level can be achieved through modulation of a volume that the bladder 56 occupies in the immersion cooling liquid.

More precisely, as shown in Figures 2 and 3, and as will be described in greater detail below, the bladder 56 is positioned such that the bladder 56 is fully submerged in the immersion cooling liquid when the bladder 56 is in the contracted state, and fully submerged in the immersion cooling liquid when the bladder 56 is in the expanded state. It is contemplated that in some embodiments, the bladder 56 could be partially submerged in the immersion cooling liquid when the bladder 56 is in the contracted state, and fully submerged in the immersion cooling liquid when the bladder 56 is in the expanded stated. In other embodiments, the bladder 56 could be partially submerged in the immersion cooling liquid when the bladder 56 is in the contracted state, and partially submerged in the immersion cooling liquid when the bladder 56 is in the expanded stated. In yet other embodiments, the bladder 56 could be fully submerged in the immersion cooling liquid when the bladder 56 is in the contracted state, and partially submerged in the immersion cooling liquid when the bladder 56 is in the expanded stated.

Furthermore, the bladder 56 is positioned in the immersion case 54 such that the bladder 56 does not contact the electronic component 80 when in the contracted state or the expanded state. In certain other embodiments, in the expanded state, a portion of the bladder 56 contacts a portion of the electronic component 80. As will be described in greater detail below, there could be heat transfer occurring between the bladder 56 and the electronic component 80.

The bladder 56 is anchored to a bottom wall of the immersion case 54 by a hook 88. It is contemplated that the bladder 56 could be anchored to the immersion case 54 by another connector such as a catch, a clasp, a latch, a clip or a grommet. It is also contemplated that in some embodiments, the bladder 56 could be anchored to another part of the immersion case 54, such as a side wall thereof or even to the serpentine convection coil 84. Anchoring the bladder 56 can help ensure that the bladder 56 remains, at least partially, submerged by the immersion cooling liquid when in the expanded state (i.e. does not float to the surface of the immersion cooling liquid). In other embodiments, the bladder 56 may not be anchored at all.

The bladder 56 is configured to house a bladder fluid therein. The bladder fluid may be a gas or a liquid. In some embodiments, the bladder fluid may be water. In other embodiments, the bladder fluid may be air. In yet other embodiments, the bladder fluid could be a coolant fluid to enhance heat transfer within the immersion case 54. As will be described in greater detail below, the bladder 56 is configured to expand to the expanded state when bladder fluid flows into the bladder 56 and is configured to contract to the contracted state when some bladder fluid flows out of the bladder 56. As will also be described below, in some embodiments, the bladder 56 could expand and contract without bladder fluid flowing in or out of the bladder 56.

The bladder 56 may have any expandable configuration which may comprise one or more folds. In certain embodiments, the bladder 56 is made of a material which is not elastically deformable and relies on unfolding of folds for volume expansion in the expanded state. In certain other embodiments, the bladder 56 is made of a material which is elastically deformable and relies predominantly on a stretching of the material for volume expansion in the expanded state.

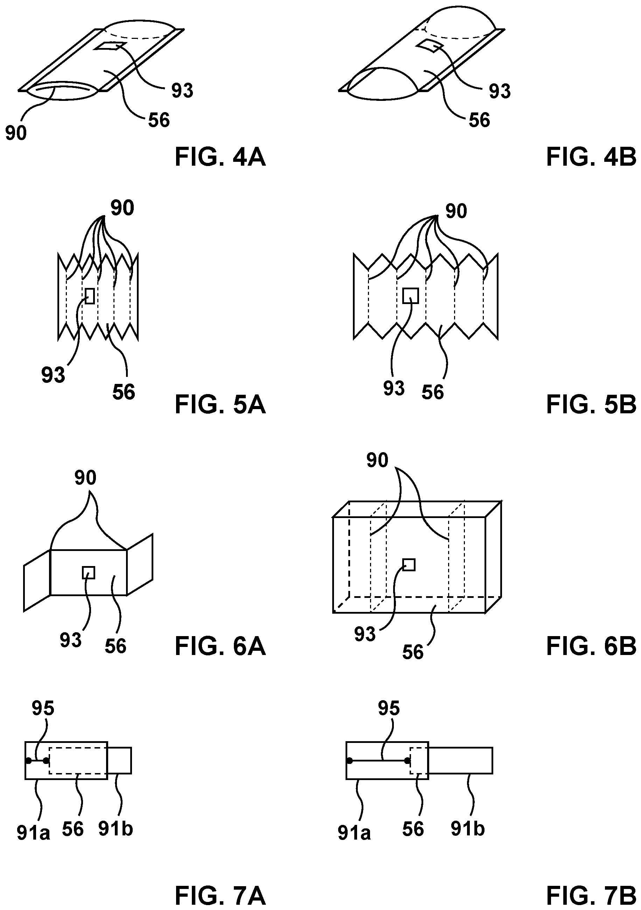

Referring to Figures 4a and 4b, an embodiment of the bladder 56 will now be described. The bladder 56 has walls that define a cavity configured to house the bladder fluid therein. The walls seal the cavity so that when the bladder 56 is filled with the bladder fluid, said bladder fluid does not mix with the immersion cooling liquid. The bladder 56 has folds 90 (only one shown in Figure 4a) in the walls. The folds 90 can unfold in the expanded state, and can fold in the contracted state. The folds 90 may be formed on any part of the walls of the bladder 56. The bladder 56 has a port 93 for permitting flow of bladder fluid in and out of the cavity. In some embodiments, there could be two or more ports 93. When the bladder 56 is in the contracted state (Figure 4a), the folds 90 are folded and the bladder 56 houses less bladder fluid than when the bladder 56 is in the expanded state (Figure 4b). In some embodiments, the bladder 56 could house no bladder fluid in the contracted state. When the bladder 56 is in the expanded state (Figure 4b), the folds 90 are unfolded, and the bladder 56 houses more bladder fluid than when the bladder 56 is in the contracted state.

In this embodiment, the bladder 56 increases in volume as it expands without elastically deforming. The bladder 56 is made from a non-elastically deformable material such as plastic. For example and without restriction, the non-elastically deformable material could be a mixture of polyethylene (PE) and polypropylene (PP) or a mixture of aluminium and PE. In addition, the non-elastically deformable material has a stiffness such that it does not crumple under pressure of the immersion cooling liquid. In other embodiments, the bladder 56 may be made of an elastically deformable material and may stretch when in the expanded state.

Referring to Figures 5a and 5b, an alternate embodiment of the bladder 56 will now be described. The bladder 56 has walls that define a cavity configured to house the bladder fluid therein. The walls seal the cavity so that when the bladder 56 is filled with the bladder fluid, said bladder fluid does not mix with the immersion cooling liquid. The bladder 56 has folds 90 that are configured as bellows. The bellows enable expansion and contraction of the bladder 56. The bladder 56 has a port 93 for permitting bladder fluid in and out of the cavity. In some embodiments, there could be two or more ports 93. When the bladder 56 is in the contracted state (Figure 5a), the bellows are contracted and the bladder 56 houses less bladder fluid than when the bladder 56 is in the expanded state. In some embodiments, the bladder 56 may be empty of bladder fluid in the contracted state. When the bladder 56 is in the expanded state (Figure 5b), the bellows are expanded and the bladder 56 houses more bladder fluid than when the bladder 56 is in the contracted state.

In this embodiment, the bladder 56 increases in volume as it expands without elastically deforming. The bladder 56 is made from a non-elastically deformable material such as plastic. For example and without restriction, the non-elastically deformable material could be a PE and PP mixture or an aluminium and PE mixture. In addition, the non-elastically deformable material has a stiffness such that it does not crumple under pressure of the immersion cooling liquid. In other embodiments, the bladder 56 may be made of an elastically deformable material and may stretch when in the expanded state.

Referring to Figures 6a and 6b, an alternate embodiment of the bladder 56 will now be described. The bladder 56 has walls that define a cavity configured to house the bladder fluid therein. The walls seal the cavity so that when the bladder 56 is filled with the bladder fluid, said bladder fluid does not mix with the immersion cooling liquid. The bladder 56 has folds 90 of the bladder 56. The folds 90 can unfold in the expanded state, and can fold in the contracted state. The bladder 56 has a port 93 for permitting bladder fluid in and out of the cavity. In some embodiments, there could be two or more ports 93. When the bladder 56 is in the contracted state (Figure 6a), the folds 90 are folded and the bladder 56 houses less bladder fluid than when in the expanded state. In some embodiments, the bladder 56 may be empty of bladder fluid in the contracted state. When the bladder 56 is in the expanded state (Figure 6b), the folds 90 are unfolded, and the bladder 56 houses more fluid than when it is in the contracted state.

The bladder 56 increases in volume and elastically deforms as it expands. The bladder 56 is made from a material that is configured to elastically deform (e.g. similar to an inflated balloon) such as a polyvinyl chloride (PVC) and ethylene-vinyl acetate (EVA) mixture. The elastically deformable material is configured to not crumple under pressure of the immersion cooling liquid. Alternatively, the bladder 56 may omit the folds 90 and rely solely on material expansion for the volume increase.

Referring to Figures 7a and 7b, an alternate embodiment of the bladder 56 will now be described in greater detail. The bladder 56 has an outer part 91a and an inner part 91b. The inner part 91b is partially received in the outer part 91a such that the bladder 56 has a telescopic configuration. In this embodiment, the bladder 56 is configured to expand and contract by an actuator 95 (i.e. the inner part 91b slides in and out of the outer part 91a). The actuator 95 could be, for example and without limitation, a hydraulic piston. The actuator 95 is communicatively connected to the controller 58. In this embodiment, the bladder 56 could house bladder fluid therein for heat transfer purposes (i.e. bladder fluid does not cause expansion or contraction).

Regardless of the configuration of the bladder 56 (i.e. whether it has folds and whether it is made of an elastically deformable material), the bladder 56 is configured to be thermally resistant up to an upper temperature reached by the immersion cooling liquid (e.g. at least 80°C) and chemically resistant to the immersion cooling liquid. In other embodiments, the bladder 56 could be thermally resistant up to at least 70°C. In yet other embodiments, the bladder 56 could be thermally resistant up to at least 60°C.

It is contemplated that in some embodiments, the cooling system 50 could include two or more bladders 56. It is further contemplated that the two or more bladders could be fluidly connected to one another, or could be fluidly sealed from one another.

A size of the bladder 56 could vary from one embodiment to another. Indeed, in some embodiments, the electrical component 80 could be relatively large, such that a relatively large amount of immersion cooling liquid would be required to achieve a given fluid level in the immersion case 54. As immersion cooling liquid can be expensive, and in order to minimize a required volume of the immersion cooling liquid, a larger bladder 56 may be more suitable to help achieve the given fluid level. In some embodiments, the bladder 56 could be configured to expand to different volumes, such that a single bladder 56 could be suitable for smaller or larger electrical components 80. In certain embodiments, a set of bladders 56 may be provided, each having a different volume capacity.

The bladder 56 is fluidly connected to a pump 92 by the port 93. The pump 92 is fluidly connected to a reservoir 94, which is configured to contain the bladder fluid, and communicatively connected to the controller 58. The pump 92 is a hydraulic pump. In some embodiments, the pump 92 could be a manual pump. It is contemplated that the pump 92 could be another type of pump, such as, for instance, a pneumatic pump. The pump 92 is also communicatively connected to the controller 58. As will be described in greater detail below, the controller 58 is configured to operate the pump 92 to cause bladder fluid to flow in or out of the bladder 56.

In some embodiments, the cooling system 50 could have a conductivity sensor disposed within the immersion case 54 that could be communicatively connected to the controller 58. The conductivity sensor could, depending on the bladder fluid, help in detecting whether or not there is a leak in the bladder 56 by measuring conductivity of the fluid in which the conductivity sensor is disposed (i.e. conductivity of the fluid would increase or decrease depending on the bladder fluid). In other embodiments, the conductivity sensor could be a pH sensor.

It is contemplated that in some embodiments of the cooling system 50, the pump 92 and the reservoir 94 could be omitted. In such embodiments, the bladder 56 may be configured to expand or contract without causing bladder fluid to flow in or out of the bladder 56 (as shown in Figures 7a and 7b). In such embodiments, the actuator 95 is communicatively connected to the controller 58.

The cooling system 50 also includes a computer system 100. The computer system 100 includes a processor 105 that is communicatively connected to the controller 58. As such, the processor 105 is communicatively connected to the level sensor 86 and to the pump 92. It is contemplated that in some embodiments, the computer system 100 could be omitted.

Still referring to Figures 1 to 3, a description of the present technology in use will now be provided.

As shown in Figure 1, the immersion case 54 is received in the rack system 52 through the front opening 70. The immersion case 54 houses the electronic component 80, the serpentine convection coil 84 and the bladder 56, which is in the contracted state. The immersion case 54 also houses the immersion cooling liquid, which is at a first fluid level when the bladder 56 is in the contracted state and at a second fluid level when the bladder 56 is in the expanded state, the second fluid level being higher than the first fluid level. The first fluid level is detected by the level sensor 86, and communicated to the controller 58 and to the processor 105. When the immersion cooling liquid is at the first fluid level, thus when the bladder 56 is in the contracted state, the electronic component 80, the serpentine convection coil 84 and the bladder 56 are only partially submerged by the immersion cooling liquid.

Then, when there is a need and/or a want to cool the electric component 80, the fluid level of the immersion cooling liquid can be increased. In response to a command provided to the controller 58 by the processor 105, the controller 58 is configured to operate the pump 92 to pump some bladder fluid from the reservoir 94 to the bladder 56. Moving bladder fluid into the bladder 56 results in the bladder 56 expanding such that a volume of the bladder 56 increases, which in turn results in the fluid level of the immersion cooling liquid increasing. In embodiments in which the bladder 56 includes the folds 90, as the bladder 56 expands, the folds 90 unfold. In some embodiments, the bladder 56 is configured to expand until the level sensor 86 detects that the immersion cooling liquid has reached a predetermined fluid level. In other embodiments, the bladder 56 could be configured to expand by a predetermined volume. In any case, the fluid level of the immersion cooling liquid increases because of the expansion of the bladder 56 until the second fluid level, higher than the first fluid level, is reached. When the immersion cooling liquid is at the second fluid level, thus when the bladder 56 is in the expanded state, the electronic component 80, the serpentine convection coil 84 and the bladder 56 are fully submerged by the immersion cooling liquid. The bladder 56 remains submerged in the immersion cooling liquid by the hook 88, which anchors the bladder 56, as, in some embodiments, depending on the material of the bladder 56 and/or density of the bladder fluid, the bladder 56 could float to a surface of the immersion cooling liquid.

In some embodiments, the controller 58 could be configured to operate the pump 92 in response to a predetermined set of conditions rather than a command. In some embodiments, the given predetermined set of conditions could be provided by the processor 105.

In other embodiments, as mentioned above, the controller 58 could be configured to modulate expansion or contraction of the bladder 56 without the pump 92 and the reservoir 94. Instead, when desired and/or needed, the controller 58 could actuate the actuator to cause expansion or contraction of the bladder 56.

When the immersion cooling liquid is at the second fluid level, hybrid cooling may occur. Cold water, or another fluid, may be carried by one of the tubes of the cable/tube bundle 74, and supplied to cooling blocks (not shown) mounted on the electronic component 80 to cool the electronic component 80. Subsequently, the water, which has increased in temperature but is expected to still be cooler than the immersion cooling liquid, is supplied to the serpentine convection coil 84. As the water flows through the serpentine convection coil 84, heat transfer between the serpentine convection coil 84 and the immersion cooling liquid induces convection of the immersion cooling liquid within the immersion case 54. The water then exits the serpentine convection coil 84 through another one of the tubes of the cable/tube bundle 74. Mounting the serpentine convention coil 84 upstream of the electronic component 80 along the path of the supplied water is also contemplated.

As shown in Figure 3, in certain embodiments, when the bladder 56 is in the expanded state, the bladder 56 is positioned to contact a portion of the electrical component 80. In some embodiments, this contact and/or the presence of the bladder 56 can help cool the electronic component 80 and/or enhance convection of the immersion cooling liquid.

In other embodiments, and referring back to Figure 1 and 2, the bladder 56 could be used to reduce the immersion cooling fluid level back to the first fluid level or to another fluid level below the second fluid level. Thus, in response to a command provided to the controller 58 by the processor 105, the controller 58 is configured to operate the pump 92 to pump some bladder fluid out of the bladder 56. In some embodiments, the command may not be provided be the processor 105. Moving bladder fluid out of the bladder 56 results in the bladder 56 contracting such that a volume of the bladder 56 decreases, which in turns results in the fluid level of the immersion cooling liquid decreasing. As the bladder 56 contracts, the folds 90 fold. In some embodiments, the bladder 56 is configured to contract until the level sensor 86 detects that the immersion cooling liquid has reached a predetermined fluid level. In other embodiments, the bladder 56 could be configured to contract to a predetermined volume. In any case, the fluid level of the immersion cooling liquid decreases until the first fluid level, or the other fluid level below the second fluid level, is reached.

In some instances, there may be a need to transport the immersion case 54. Having a lower fluid level can help to reduce chances of the immersion cooling fluid spilling out of the immersion case 54. In addition, when there is a need to access the electrical component 80, having a lower fluid level can facilitate access to the electrical component 80. Furthermore, reducing the amount of immersion cooling fluid required to submerge an electrical component 80 in a given immersion case 54 using the bladder 56, can help reduce costs of the cooling system 50. Additionally, the bladder 56 permits quick fluid level adjustment. This can be useful when swift adjustability is required.

Referring to Figure 4, a method 110 executed by the processor 102 of the computer system 100 will now be described. As mentioned above, the processor 102 is communicatively connected to the controller 58.

The method 110 begins at step 112 with the processor 102 detecting the fluid level of the immersion cooling liquid in the immersion case 54. The fluid level is detected by the level sensor 86, which communicates with the controller 58, which in turns communicates with the processor 102. In other embodiments, the fluid level of the immersion cooling liquid could be detected by detecting the volume of the bladder 56 and deriving the immersion cooling liquid fluid level therefrom. In response to the detected fluid level, the processor 102 is configured to cause modulation of the bladder 56.

Then, at step 114, the processor 102 is configured to modulate the bladder 56 between the expanded state and the contracted state by communicating commands with the controller 58, which in turns communicates with the pump 92 to modulate the bladder 56 between the expanded and contracted states.

Modifications and improvements to the above-described implementations of the present technology may become apparent to those skilled in the art. The foregoing description is intended to be exemplary rather than limiting. The scope of the present technology is therefore not intended to be limited by specificities of the shown examples.

## Claims

1. A cooling system (50) comprising:
an immersion case (54) configured to house:
an immersion cooling liquid, and
an electronic component (80) configured to be submerged in the immersion cooling
liquid; and
a bladder (56) configurable between an expanded state and a contracted state and positioned such that:
the bladder (56) is at least partially submerged in presence of the immersion cooling liquid in the immersion case (54),
when the bladder (56) is in the expanded state, the immersion cooling liquid is at a first level in the immersion case (54) and the electronic component (80) is fully submerged in the immersion cooling liquid, and
when the bladder (56) is in the contracted state, the immersion cooling liquid is at a second level in the immersion case (54), the second level being lower than the first level;
a controller (58) connected to the bladder (56) for modulating the bladder (56) between the expanded state and the contracted state to modulate a fluid level of the immersion cooling liquid in the immersion case (54); and
a rack system (52) configured to receive the immersion case (54);
**characterized in that**:
the controller (58) is configured to modulate the bladder (56) to the contracted state when at least one of the rack system (52), having received the immersion case, and the immersion case (54) is displaced.

2. The cooling system (50) of claim 1, wherein the bladder (56) comprises at least one fold (90), the at least one fold (90) being unfolded in the expanded state and folded in the contracted state.

3. The cooling system (50) of claim 1 or claim 2, wherein the bladder (56) is made of an elastically deformable material.

4. The cooling system (50) of any of claims 1 to 3, wherein the bladder (56) is made of a material which is thermally resistant up to at least 60°C.

5. The cooling system (50) of any of claims 1 to 4, wherein the bladder (56) is configured to be anchored to the immersion case (54).

6. The cooling system (50) of claim 5, wherein the bladder (56) is positioned to contact a portion of the electronic component (80) in the expanded state to draw heat away from the electronic component (80) when in contact with the electronic component (80).

7. The cooling system (50) of any of claims 1 to 6, wherein:
the bladder (56) is configured to house a bladder fluid, the bladder fluid being a gas or a liquid; and
the cooling system (50) comprising a pump (92) communicatively connected to the controller (58) and fluidly connected to the bladder (56), the pump (92) being configured to move the bladder fluid in and out of the bladder (56).

8. The cooling system (50) of claim 7, further comprising a reservoir (94) fluidly connected to the pump (92).

9. The cooling system (50) of any of claims 1 to 6, further comprising a level sensor (86) configured to detect the fluid level of the immersion cooling liquid in the immersion case (54).

10. The cooling system (50) of claim 9, wherein the controller (58) is communicatively connected to the level sensor (86) and to a pump (92), the pump (92) being communicatively connected to the controller (58) and fluidly connected to the bladder (56), the pump (92) being configured to move the bladder fluid in and out of the bladder (56), the controller (58) being configured to control a state of the bladder in response to data received from the level sensor (86).

11. The cooling system (50) of any of claims 1 to 10, wherein the bladder (56) comprises a plurality of bladders (56) which are fluidly connected to one another.

12. A method (110) for operating a cooling system (50), the cooling system (50) comprising an immersion case (54) housing immersion cooling liquid, a rack system (52) receiving the immersion case (54), an electronic component (80), and a bladder (56), the method (110) being executed by a processor (105) of a computer system (100) communicatively coupled to a controller (58) of the cooling system (50), the method (110) comprising:
modulating the bladder (56) between an expanded state and a contracted state, the bladder (56) being positioned in the immersion case (54) such that the bladder (56) is at least partially submerged in the immersion cooling liquid to modulate a level of the immersion cooling liquid in the immersion case (54) and to selectively submerge the electronic component (80), the immersion cooling liquid being at a first level in the immersion case (54) when the bladder (56) is in the expanded state so that the electronic component (80) is fully submerged in the immersion cooling liquid, the immersion cooling liquid being at a second level in the immersion case (54) when the bladder (56) is in the contracted state, the second level being lower than the first level;
**characterized in that** the method (110) further comprises:
modulating the bladder (56) to the contracted state when at least one of the rack system (52) and the immersion case (54) is displaced.

13. The method (110) of claim 12, further comprising:
detecting the level of the immersion cooling liquid in the immersion case (54), and responsive to the detected level of the immersion cooling liquid being a predetermined level, causing the modulation of the bladder (56).

## Patentansprüche

1. Kühlsystem (50), umfassend:
ein Tauchgehäuse (54), das dazu konfiguriert ist, Folgendes zu enthalten:
eine Tauchkühlflüssigkeit und
ein elektronisches Bauteil (80), das dazu konfiguriert ist, in die Tauchkühlflüssigkeit eingetaucht zu werden; und
eine Blase (56), die zwischen einem ausgedehnten Zustand und einem zusammengezogenen Zustand konfigurierbar ist und derart positioniert ist, dass:
die Blase (56) in Gegenwart der Tauchkühlflüssigkeit zumindest teilweise in dem Tauchgehäuse (54) eingetaucht ist,
sich die Tauchkühlflüssigkeit bei einem ersten Füllstand in dem Tauchgehäuse (54) befindet und das elektronische Bauteil (80) vollständig in die Tauchkühlflüssigkeit eingetaucht ist, wenn sich die Blase (56) im ausgedehnten Zustand befindet, und
sich die Tauchkühlflüssigkeit bei einem zweiten Füllstand in dem Tauchgehäuse (54) befindet, wenn sich die Blase (56) im zusammengezogenen Zustand befindet, wobei der zweite Füllstand niedriger ist als der erste Füllstand;
eine Steuerung (58), die mit der Blase (56) verbunden ist, um die Blase (56) zwischen dem ausgedehnten Zustand und dem zusammengezogenen Zustand zu modulieren, um einen Fluidfüllstand der Tauchkühlflüssigkeit in dem Tauchgehäuse (54) zu modulieren; und
ein Rahmensystem (52), das dazu konfiguriert ist, das Tauchgehäuse (54) aufzunehmen;
**dadurch gekennzeichnet, dass**
die Steuerung (58) dazu konfiguriert ist, die Blase (56) in den zusammengezogenen Zustand zu modulieren, wenn mindestens eines von dem Rahmensystem (52), das das Tauchgehäuse aufgenommen hat, und dem Tauchgehäuse (54) verschoben wird.

2. Kühlsystem (50) nach Anspruch 1, wobei die Blase (56) mindestens eine Falte (90) aufweist, wobei die mindestens eine Falte (90) im ausgedehnten Zustand entfaltet ist und im zusammengezogenen Zustand gefaltet ist.

3. Kühlsystem (50) nach Anspruch 1 oder Anspruch 2, wobei die Blase (56) aus einem elastisch verformbaren Material hergestellt ist.

4. Kühlsystem (50) nach einem der Ansprüche 1 bis 3, wobei die Blase (56) aus einem Material hergestellt ist, das bis mindestens 60 °C wärmebeständig ist.

5. Kühlsystem (50) nach einem der Ansprüche 1 bis 4, wobei die Blase (56) dazu konfiguriert ist, an dem Tauchgehäuse (54) verankert zu werden.

6. Kühlsystem (50) nach Anspruch 5, wobei die Blase (56) positioniert ist, um im ausgedehnten Zustand einen Abschnitt des elektronischen Bauteils (80) zu berühren, um bei Kontakt mit dem elektronischen Bauteil (80) Wärme von dem elektronischen Bauteil (80) abzuleiten.

7. Kühlsystem (50) nach einem der Ansprüche 1 bis 6, wobei:
die Blase (56) dazu konfiguriert, ein Blasenfluid aufzunehmen, wobei das Blasenfluid ein Gas oder eine Flüssigkeit ist; und
wobei das Kühlsystem (50) eine Pumpe (92) umfasst, die mit der Steuerung (58) kommunikativ verbunden ist und mit der Blase (56) in Fluidverbindung steht, wobei die Pumpe (92) dazu konfiguriert ist, das Blasenfluid in die Blase (56) hinein und aus dieser heraus zu bewegen.

8. Kühlsystem (50) nach Anspruch 7, ferner umfassend einen Vorratsbehälter (94), der mit der Pumpe (92) in Fluidverbindung steht.

9. Kühlsystem (50) nach einem der Ansprüche 1 bis 6, ferner umfassend einen Füllstandsensor (86), der dazu konfiguriert ist, den Fluidfüllstand der Tauchkühlflüssigkeit in dem Tauchgehäuse (54) zu erfassen.

10. Kühlsystem (50) nach Anspruch 9, wobei die Steuerung (58) kommunikativ mit dem Füllstandsensor (86) und einer Pumpe (92) verbunden ist, wobei die Pumpe (92) kommunikativ mit der Steuerung (58) verbunden ist und mit der Blase (56) in Fluidverbindung steht, wobei die Pumpe (92) dazu konfiguriert ist, das Blasenfluid in die Blase (56) hinein und aus dieser heraus zu bewegen, wobei die Steuerung (58) dazu konfiguriert ist, einen Zustand der Blase als Reaktion auf von dem Füllstandsensor (86) empfangene Daten zu steuern.

11. Kühlsystem (50) gemäß einem der Ansprüche 1 bis 10, wobei die Blase (56) eine Vielzahl von Blasen (56) umfasst, die miteinander in Fluidverbindung stehen.

12. Verfahren (110) zum Betreiben eines Kühlsystems (50), wobei das Kühlsystem (50) ein Tauchgehäuse (54), das Tauchkühlflüssigkeit enthält, ein Rahmensystem (52), das das Tauchgehäuse (54) aufnimmt, ein elektronisches Bauteil (80) und eine Blase (56) umfasst, wobei das Verfahren (110) durch einen Prozessor (105) eines Computersystems (100) ausgeführt wird, das kommunikativ an eine Steuerung (58) des Kühlsystems (50) gekoppelt ist, wobei das Verfahren (110) Folgendes umfasst:
Modulieren der Blase (56) zwischen einem ausgedehnten Zustand und einem zusammengezogenen Zustand, wobei die Blase (56) derart in dem Tauchgehäuse (54) positioniert ist, dass die Blase (56) zumindest teilweise in die Tauchkühlflüssigkeit eingetaucht ist, um einen Füllstand der Tauchkühlflüssigkeit in dem Tauchgehäuse (54) zu modulieren und das elektronische Bauteil (80) selektiv einzutauchen, wobei sich die Tauchkühlflüssigkeit bei einem ersten Füllstand in dem Tauchgehäuse (54) befindet, wenn sich die Blase (56) in dem ausgedehnten Zustand befindet, sodass das elektronische Bauteil (80) vollständig in die Tauchkühlflüssigkeit eingetaucht ist, wobei sich die Tauchkühlflüssigkeit bei einem zweiten Füllstand in dem Tauchgehäuse (54) befindet, wenn sich die Blase (56) in dem zusammengezogenen Zustand befindet, wobei der zweite Füllstand niedriger ist als der erste Füllstand;
**dadurch gekennzeichnet, dass** das Verfahren (110) ferner Folgendes umfasst:
Modulieren der Blase (56) in den zusammengezogenen Zustand, wenn mindestens eines von dem Rahmensystem (52) und dem Tauchgehäuse (54) verschoben wird.

13. Verfahren (110) nach Anspruch 12, ferner umfassend:
Erfassen des Füllstands der Tauchkühlflüssigkeit in dem Tauchgehäuse (54) und Veranlassen der Modulation der Blase (56) als Reaktion darauf, dass der erfasste Füllstand der Tauchkühlflüssigkeit ein vorbestimmter Füllstand ist.

## Revendications

1. Système de refroidissement (50) comprenant :
un boîtier d'immersion (54) configuré pour contenir :
un liquide de refroidissement par immersion, et
un composant électronique (80) configuré pour être immergé dans le liquide de refroidissement par immersion ; et
une vessie (56) configurable entre un état expansé et un état contracté et positionnée de telle sorte que :
la vessie (56) est au moins partiellement immergée en présence du liquide de refroidissement par immersion dans le boîtier d'immersion (54),
lorsque la vessie (56) est à l'état expansé, le liquide de refroidissement par immersion se trouve à un premier niveau dans le boîtier d'immersion (54) et le composant électronique (80) est entièrement immergé dans le liquide de refroidissement par immersion, et
lorsque la vessie (56) est à l'état contracté, le liquide de refroidissement par immersion se trouve à un second niveau dans le boîtier d'immersion (54), le second niveau étant inférieur au premier niveau ;
un dispositif de commande (58) connecté à la vessie (56) pour moduler la vessie (56) entre l'état expansé et l'état contracté afin de moduler un niveau de fluide du liquide de refroidissement par immersion dans le boîtier d'immersion (54) ; et
un système de support (52) configuré pour recevoir le boîtier d'immersion (54) ;
**caractérisé en ce que** :
le dispositif de commande (58) est configuré pour moduler la vessie (56) jusqu'à l'état contracté lorsqu'au moins l'un parmi le système de support (52), ayant reçu le boîtier d'immersion, et le boîtier d'immersion (54) est déplacé.

2. Système de refroidissement (50) selon la revendication 1, dans lequel la vessie (56) comprend au moins un pli (90), l'au moins un pli (90) étant déplié à l'état expansé et plié à l'état contracté.

3. Système de refroidissement (50) selon la revendication 1 ou la revendication 2, dans lequel la vessie (56) est constituée d'un matériau élastiquement déformable.

4. Système de refroidissement (50) selon l'une quelconque des revendications 1 à 3, dans lequel la vessie (56) est constituée d'un matériau qui est thermiquement résistant jusqu'à au moins 60 °C.

5. Système de refroidissement (50) selon l'une quelconque des revendications 1 à 4, dans lequel la vessie (56) est configurée pour être ancrée au boîtier d'immersion (54).

6. Système de refroidissement (50) selon la revendication 5, dans lequel la vessie (56) est positionnée pour entrer en contact avec une partie du composant électronique (80) dans l'état expansé pour évacuer la chaleur du composant électronique (80) lorsqu'il est en contact avec le composant électronique (80).

7. Système de refroidissement (50) selon l'une quelconque des revendications 1 à 6, dans lequel :
la vessie (56) est configurée pour contenir un fluide de vessie, le fluide de vessie étant un gaz ou un liquide ; et
le système de refroidissement (50) comprenant une pompe (92) connectée en communication au dispositif de commande (58) et reliée fluidiquement à la vessie (56), la pompe (92) étant configurée pour déplacer le fluide de vessie dans et hors de la vessie (56).

8. Système de refroidissement (50) selon la revendication 7, comprenant en outre un réservoir (94) relié fluidiquement à la pompe (92).

9. Système de refroidissement (50) selon l'une quelconque des revendications 1 à 6, comprenant en outre un capteur de niveau (86) configuré pour détecter le niveau de liquide du liquide de refroidissement par immersion dans le boîtier d'immersion (54).

10. Système de refroidissement (50) selon la revendication 9, dans lequel le dispositif de commande (58) est connecté en communication au capteur de niveau (86) et à une pompe (92), la pompe (92) étant connectée en communication au dispositif de commande (58) et reliée fluidiquement à la vessie (56), la pompe (92) étant configurée pour déplacer le liquide de vessie dans et hors de la vessie (56), le dispositif de commande (58) étant configuré pour commander un état de la vessie en réponse aux données reçues du capteur de niveau (86).

11. Système de refroidissement (50) selon l'une quelconque des revendications 1 à 10, dans lequel la vessie (56) comprend une pluralité de vessies (56) qui sont reliées fluidiquement les unes avec les autres.

12. Procédé (110) pour faire fonctionner un système de refroidissement (50), le système de refroidissement (50) comprenant un boîtier d'immersion (54) contenant un liquide de refroidissement par immersion, un système de support (52) recevant le boîtier d'immersion (54), un composant électronique (80), et une vessie (56), le procédé (110) étant exécuté par un processeur (105) d'un système informatique (100) couplé en communication à un dispositif de commande (58) du système de refroidissement (50), le procédé (110) comprenant :
la modulation de la vessie (56) entre un état expansé et un état contracté, la vessie (56) étant positionnée dans le boîtier d'immersion (54) de telle sorte que la vessie (56) est au moins partiellement immergée dans le liquide de refroidissement par immersion pour moduler un niveau du liquide de refroidissement par immersion dans le boîtier d'immersion (54) et pour immerger sélectivement le composant électronique (80), le liquide de refroidissement par immersion se trouvant à un premier niveau dans le boîtier d'immersion (54) lorsque la vessie (56) est à l'état expansé de sorte que le composant électronique (80) est entièrement immergé dans le liquide de refroidissement par immersion, le liquide de refroidissement par immersion se trouvant à un second niveau dans le boîtier d'immersion (54) lorsque la vessie (56) est à l'état contracté, le second niveau étant inférieur au premier niveau ;
**caractérisé en ce que** le procédé (110) comprend en outre :
la modulation de la vessie (56) jusqu'à l'état contracté lorsqu'au moins l'un parmi le système de support (52) et le boîtier d'immersion (54) est déplacé.

13. Procédé (110) selon la revendication 12, comprenant en outre :
la détection du niveau du liquide de refroidissement par immersion dans le boîtier d'immersion (54), et en réponse au niveau détecté du liquide de refroidissement par immersion étant un niveau prédéterminé, le fait de provoquer la modulation de la vessie (56).
